# EUROPEAN PATENT APPLICATION

(11) **EP 1 675 449 A1**
(43) Date of publication of application: **28.06.2006**
(21) Application number: 05027059.4
(22) Date of filing: 12.12.2005
(51) Int. Cl.: H05K 3/46, H05K 1/16

(54) **Devices comprising a power core and methods of making thereof**

(30) Priority: 21.12.2004 US 638001 P; 30.11.2005 US 289884 P
(71) Applicant: E.I. du Pont de Nemours and Company, Wilmington, DE 19898 (US)
(72) Inventor: Amey, Daniel Irwin, Jr., Durham, North Carolina 27705 (US); Banerji, Sounak, Cary, North Carolina 27513 (US); Borland, William J., Cary, North Carolina 27513 (US); McGregor, David Ross, Apex, North Carolina 27539 (US); Sreeram, Attiganal N., Raleigh, North Carolina 27614 (US); Dietz, Karl Hartmann, Raleigh, North Carolina 27613 (US)
(74) Representative: Towler, Philip Dean

(57) **Abstract**

A power core comprising: at least one embedded singulated capacitor layer containing at least one embedded singulated capacitor (240); and at least one planar capacitor laminate (340); wherein at least one planar capacitor laminate (340) serves as a low inductance path to supply a charge to at least one embedded singulated capacitor (240); and wherein said embedded singulated capacitor (240) is connected in parallel to said planar capacitor laminate (340).

## Description

### FIELD OF THE INVENTION

The technical field relates to decoupling devices having both low inductance and high capacitance functions, and methods of incorporating such devices in organic dielectric laminates and printed wiring boards.

### BACKGROUND OF THE INVENTION

As semiconductor devices including integrated circuits (IC) operate at higher frequencies, higher data rates and lower voltages, noise in the power and ground (return) lines and supplying sufficient current to accommodate faster circuit switching becomes an increasingly important problem requiring low impedance in the power distribution system. In order to provide low noise, stable power to the IC, impedance in conventional circuits is reduced by the use of additional surface mount capacitors interconnected in parallel. The higher operating frequencies (higher IC switching speeds) mean that voltage response times to the IC must be faster. Lower operating voltages require that allowable voltage variations (ripple) and noise become smaller. For example, as a microprocessor IC switches and begins an operation, it calls for power to support the switching circuits. If the response time of the voltage supply is too slow, the microprocessor will experience a voltage drop or power droop that will exceed the allowable ripple voltage and noise margin and the IC will malfunction. Additionally, as the IC powers up, a slow response time will result in power overshoot. Power droop and overshoot must be controlled within allowable limits by the use of capacitors that are close enough to the IC that they provide or absorb power within the appropriate response time.

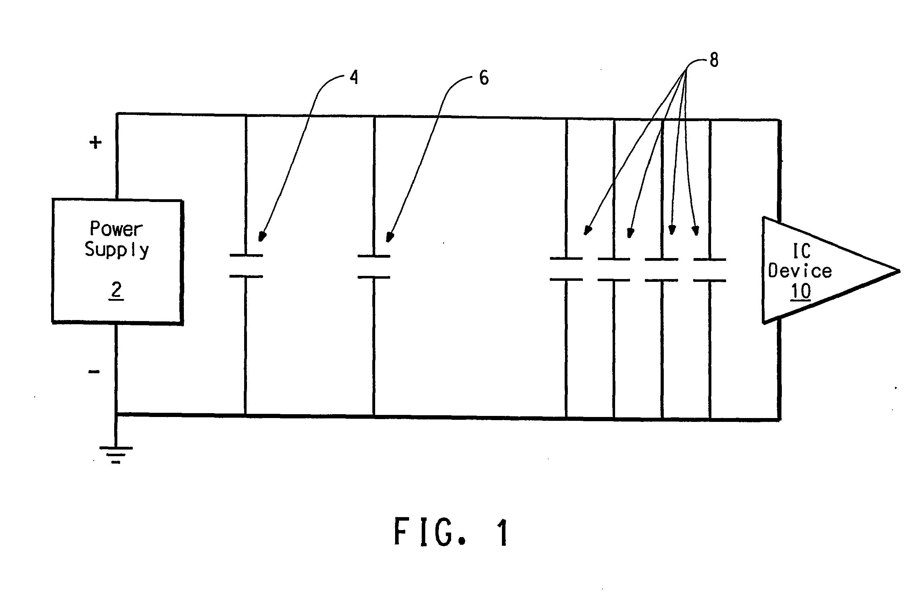

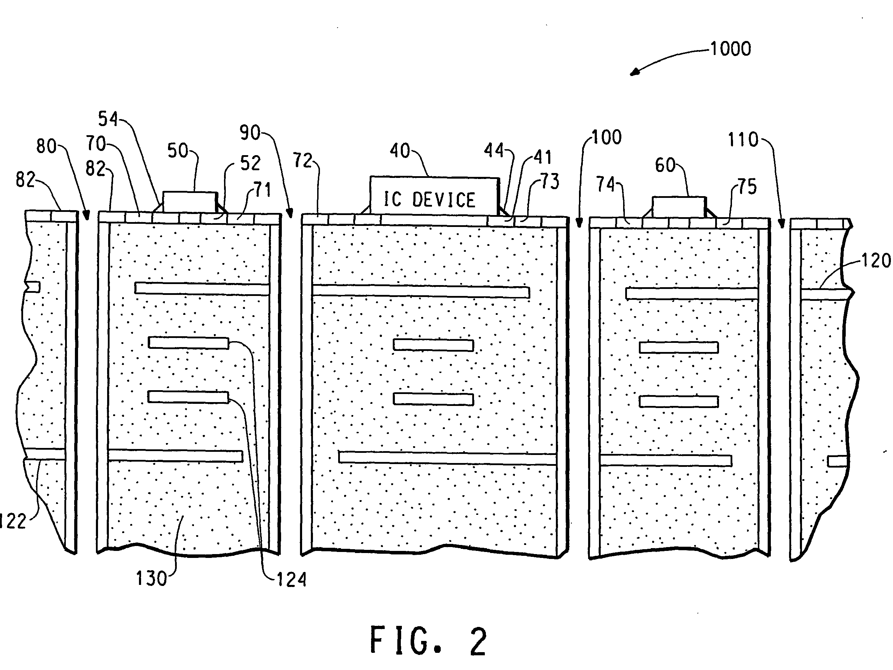

Capacitors for impedance reduction and dampening power droop or overshoot are generally placed as close to the IC as possible to improve circuit performance. Conventional designs have capacitors surface mounted on a printed wiring board (PWB) clustered around the IC. Large value capacitors are placed near the power supply, mid-range value capacitors at locations between the IC and the power supply and small value capacitors very near the IC. **FIG. 1** is a schematic illustration of a power supply **2,** an IC **10** and the capacitors **4, 6, 8,** which represent high value, mid-range value and small value capacitors, respectively, used for impedance reduction and dampening power droop or overshoot as described above. **FIG. 2** is a representative section view in front elevation showing the connections of the SMT capacitors **50** and **60** and IC **40** to the power and ground planes in the substrate of the PWB. IC device **40** is connected to lands **41** by solder filets **44.** Lands **41** are connected to plated-through hole via (via) pads of vias **90** and **100** by circuit lines **72** and **73.** Via pads are shown generically as **82.** Via **90** is electrically connected to conductor plane **120** and via **100** is connected to conductor plane **122.** Conductor planes **120** and **122** are connected one to the power side of the power supply and the other to the ground-side of the power supply. Small value capacitors **50** and **60** are similarly electrically connected to vias and conductor planes **120** and **122** in such a way that they are electrically connected to IC **40** in parallel. In the case of lCs placed on modules, interposers, or packages, the large and medium value capacitors may reside on the printed wiring mother board to which the modules, interposers, or packages are attached.

Large numbers of capacitors, interconnected in parallel, are often required to reduce power system impedance requiring complex electrical routing. This leads to increased circuit loop inductance, which in turn increases impedance, constraining current flow, thereby reducing the beneficial effects of the surface mounted capacitors. As frequencies increase and operating voltages continue to drop, increased power must be supplied at faster rates requiring increasingly lower inductance and impedance levels.

Considerable effort has been expended to minimize impedance. U.S. 5,161,086 to Howard, et al., provides one approach to minimizing impedance and "noise". Howard, et al., provides a capacitive printed circuit board with a capacitor laminate (planar capacitor) included within the multiple layers of the laminated board, a large number of devices such as integrated circuits being mounted or formed on the board and operatively coupled with the capacitor laminate (or multiple capacitor laminates) to provide a capacitive function employing borrowed or shared capacitance. However, such an approach does not necessarily improve voltage response. Improved voltage response requires that the capacitor is placed closer to the IC. Simply placing the capacitor laminate closer to the IC may not be sufficient because the total capacitance available may be insufficient.

U.S. 6,611,419 to Chakravorty provides for an alternate approach to embedding capacitors to reduce switching noise wherein the power supply terminals of an integrated circuit die can be coupled to the respective terminals of at least one embedded capacitor in a multilayer ceramic substrate.

Accordingly, the present inventors desired to provide a method of making and design of a power core for use in integrated circuit packages or other interconnecting boards, structures or elements that allows for superior power distribution impedance reduction combined with improved voltage response to accommodate higher IC switching speeds. The present invention provides such a device and method of making such a device.

### SUMMARY

One embodiment of the present invention is directed to a power core comprising: at least one embedded singulated capacitor layer comprising at least one embedded singulated capacitor; and at least one planar capacitor laminate; wherein at least one planar capacitor laminate serves as a low inductance path to supply a charge to at least one embedded singulated capacitor; and wherein said embedded singulated capacitor is connected in parallel to said planar capacitor laminate.

The present invention is further directed to a method for making a power core structure comprising: providing a planar capacitor laminate having a patterned side and a non-patterned side; providing a formed on foil singulated capacitor structure having a foil side and a component side; and laminating said component side of said formed on foil singulated capacitor structure to said patterned side of said planar capacitor laminate.

An additional embodiment of the present invention provides a method for making a power core structure comprising: providing a planar capacitor laminate having a first patterned side and a second patterned side; providing a formed on foil singulated capacitor structure having a foil side and a component side; and laminating said component side of said formed on foil singulated capacitor structure to said first patterned side of said planar capacitor laminate.

Yet a further embodiment includes a method for making a power core structure comprising: providing a planar capacitor laminate having at least one patterned side; providing at least one foil structure comprising at least one formed-on-foil singulated capacitor, having a foil side and a component side; and laminating said foil side of said foil structure to said patterned side of said planar capacitor structure; etching said foil side of said foil structure and etching said non-patterned side of said planar capacitor structure ; and connecting said singulated capacitor structure in parallel to said planar capacitor laminate.

### BRIEF DESCRIPTION OF THE DRAWINGS

The detailed description will refer to the following drawings, wherein like numerals refer to like elements, and wherein:
**FIG. 1** is a schematic illustration of typical prior art use of capacitors for impedance reduction and dampening power droop or overshoot;
**FIG. 2** is a representation in section view in front elevation of a printed wiring assembly having conventional prior art surface mount (SMT) capacitors used for impedance reduction and dampening power droop or overshoot;
**FIG. 3** is a representation in section view in front elevation of a power core device according to a first embodiment;
**FIGS. 4A-4F** illustrate a method of making singulated thick-film fired-on-foil capacitors;
**FIGS. 5A-5B** illustrate a method of making a planar capacitor laminate;
**FIGS. 6A-6B** illustrate initial preparation of a planar capacitor laminate for manufacture of the power core device according to a first embodiment;
**FIG. 7** is a representation in section view in front elevation of a power core structure subpart according to a first embodiment;
**FIG. 8** is a representation in section view in front elevation of a power core structure according to a first embodiment.
**FIG. 9** is a Type A discrete capacitor design viewed from the foil side.
**FIG. 10** is a Type B discrete capacitor design viewed from the foil side.
**FIG. 11** is a Type C discrete capacitor design viewed from the foil side.

### DETAILED DESCRIPTION

Embodiments of the present invention are addressed to a power core structure that may be buried in the substrate of a printed wiring board (PWB), module, interposer, or package. Providing the low inductance and high capacitance functions of the power core within the PWB, module, interposer, or package substrate conserves valuable surface real estate on the PWB, module, interposer, or package and also requires fewer solder joints than conventional SMT capacitor arrangements.

According to a first embodiment, a design and manufacturing method of a power core structure is disclosed in which singulated capacitor(s) and planar capacitor laminate(s) are connected in parallel embedded within a laminate structure to create a power core structure. Singulated capacitors may be defined as individual capacitors formed on metal. Typically, the metal is a metal foil. Although we use the term "foil" herein, it is understood that foil encompasses a general metal layer, plated metal, sputtered metal, etc. The singulated capacitors in the power core structure are designed to be as close as possible to the power terminals of the IC for a rapid voltage response to the IC to support high switching speeds. Placing the singulated capacitors as close as possible to the power terminals of the IC also provides for low inductance connections. The planar capacitor laminate is used as the power-ground planes and the power-ground plane separation is made thin to reduce high frequency impedance in the package.

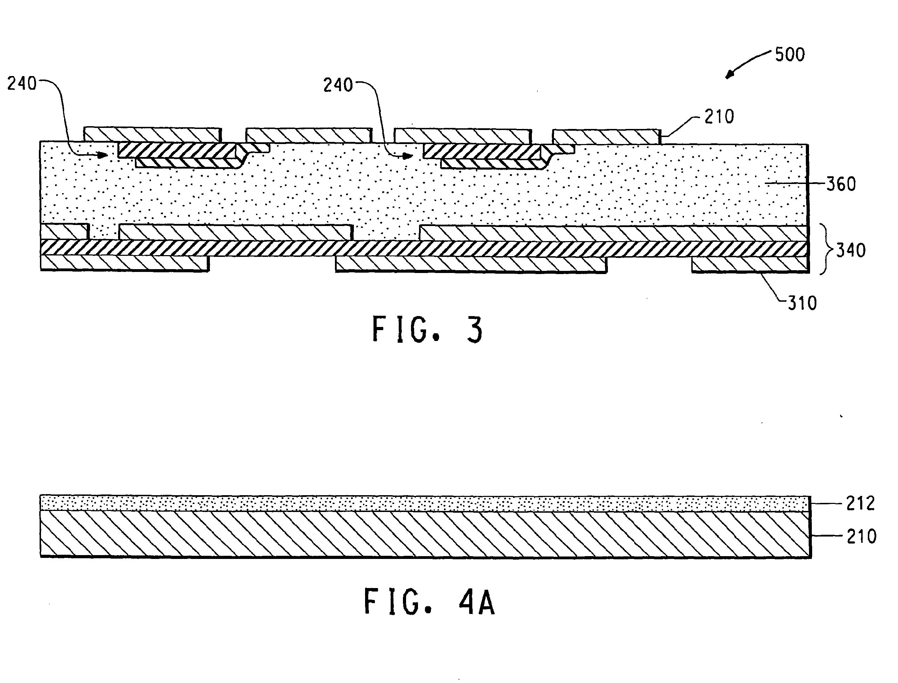

FIG. 3 is a representation in section view in front elevation of a power core device **500** of the present invention. The above embodiment allows for a foil containing the singulated capacitors to be formed with various materials and subsequently laminated to the planar capacitor laminate to form the power core structure. Such materials may include the use of high K ceramic-filled polymer thick-film capacitor dielectric and metal filled polymer thick-film electrode pastes screen-printed and cured on to the metal foil. Etching of conventional planar capacitor laminates, such as copper/polyimide/copper laminates like HK 04 obtainable from E. I. du Pont de Nemours and Company, may also be employed to form singulated capacitors on copper foil. Such polymer-based capacitors, however, have relatively low capacitance and it is generally desirable that the singulated capacitors have a high capacitance. In such a case, formed-on-foil, including fired-on-foil, techniques may be preferably employed to make singulated ceramic capacitors on foil using ceramic compositions. Such capacitors may be formed from thin-film or thick-film approaches. The foil containing said capacitors may be laminated to the planar capacitor using standard printed wiring board lamination processes to form the power core structure.

The above embodiment also allows for the planar capacitor to be formed using various materials. Such materials may include metal foil-dielectric-metal foil laminate structures wherein the dielectric may comprise an organic layer, a ceramic-filled organic layer, or a ceramic layer. Where multiple layers are used, layers may be of different materials. Such dielectrics would be manufactured with thin layers for impedance reduction. The planar capacitor may be laminated to the capacitors formed-on-foil by standard printing wiring board lamination processes to form the power core device.

According to the above embodiment, both the low impedance and high capacitance functions may be integrated into a single power core structure that can be further integrated into another laminate structure, permitting operation of high-speed lCs at lower voltages with reduced voltage ripple. When the power core structure is incorporated in a printed wiring board, module, interposer, or package, valuable real estate becomes available. Further, solder joints associated with SMT devices may be eliminated, thereby improving reliability. The power core structure can be processed using conventional printed wiring board processes, further reducing production costs.

Those skilled in the art will appreciate the above stated advantages and other advantages and benefits of various embodiments of the invention upon reading this detailed description of the embodiments with reference to the below-listed drawings.

According to common practice, the various features of the drawings are not necessarily drawn to scale. Dimensions of various features may be expanded or reduced to more clearly illustrate the embodiments of the invention.

**FIG. 3** illustrates, in side elevation, a power core device **500** comprising a planar capacitor laminate **340** and formed-on-foil singulated capacitors **240.** according to a first embodiment.

**FIGS. 4A-4F** illustrate, in side elevation, a general method of manufacturing single-layer formed-on-foil singulated capacitors.

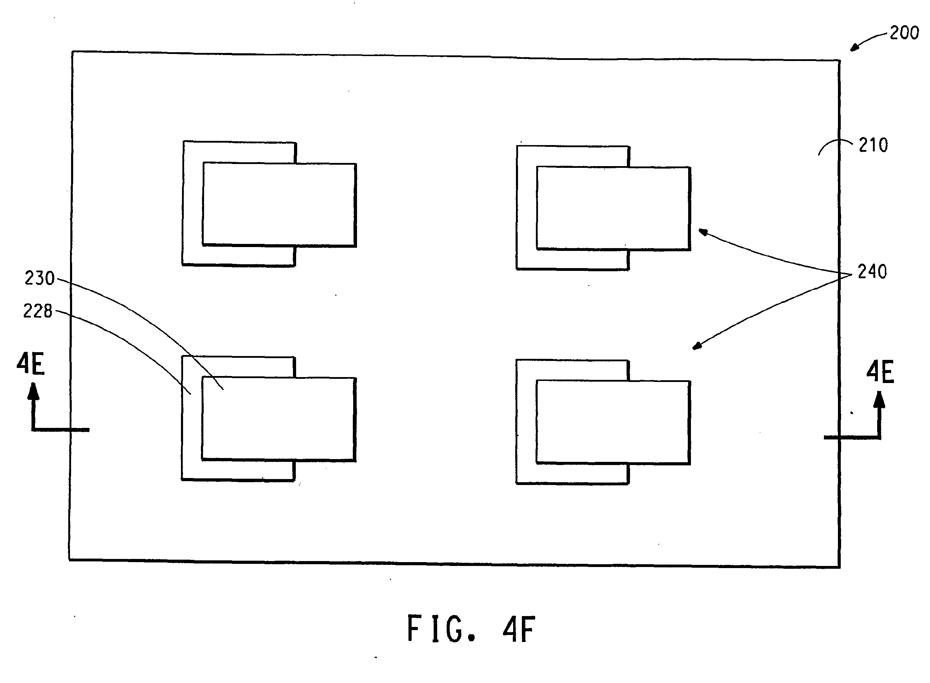

**FIG. 4F** is a plan view of the finished formed-on-foil capacitors. Specific examples of thick-film fired-on-foil capacitors are described below to illustrate one embodiment of the present invention.

**FIG. 4A** is a side elevational view of a first stage of manufacturing the singulated capacitor structure **200.** In **FIG. 4A,** a metallic foil **210** is provided. The foil **210** may be of a type generally available in the industry. For example, the foil **210** may be copper, copper-invar-copper, invar, nickel, nickel-coated copper, or other metals that have melting points in excess of the firing temperature for thick-film pastes. Preferred foils include foils comprised predominantly of copper, such as reverse treated copper foils, double-treated copper foils, and other copper foils commonly used in the multilayer printed circuit board industry. The thickness of the foil **210** may be in the range of, for example, about 1-100 microns, preferably 3-75 microns, and most preferably 12-36 microns, corresponding to between about 1/3 oz and 1 oz copper foil. An example of a suitable foil is PLSP grade 1 ounce copper foil obtainable from Oak-Mitsui.

The foil **210** may be pretreated by applying an underprint **212** to the foil **210.** The underprint **212** is a relatively thin layer applied to a component-side surface of the foil **210.** In **FIG. 4A,** the underprint **212** is indicated as a surface coating on the foil **210.** The underprint **212** adheres well to the metal foil **210** and to layers deposited over the underprint **212.** The underprint **212** may be formed, for example, from a paste applied to the foil **210,** and is then fired in an inert atmosphere at a temperature below the melting point of the foil **210.** The paste may be printed as an open coating over the entire surface of the foil **210,** or printed on selected areas of the foil **210.** It is generally more economical to print the underprint paste over selected areas of the foil. When a copper foil **210** is used in conjunction with a copper underprint **212,** glass in the copper underprint paste retards oxidative corrosion of the copper foil **210,** and it may therefore be preferable to coat the entire surface of the foil **210** if oxygen-doped firing is utilized. An example of a suitable copper underprint is EP 320 available from E. I. du Pont de Nemours and Company.

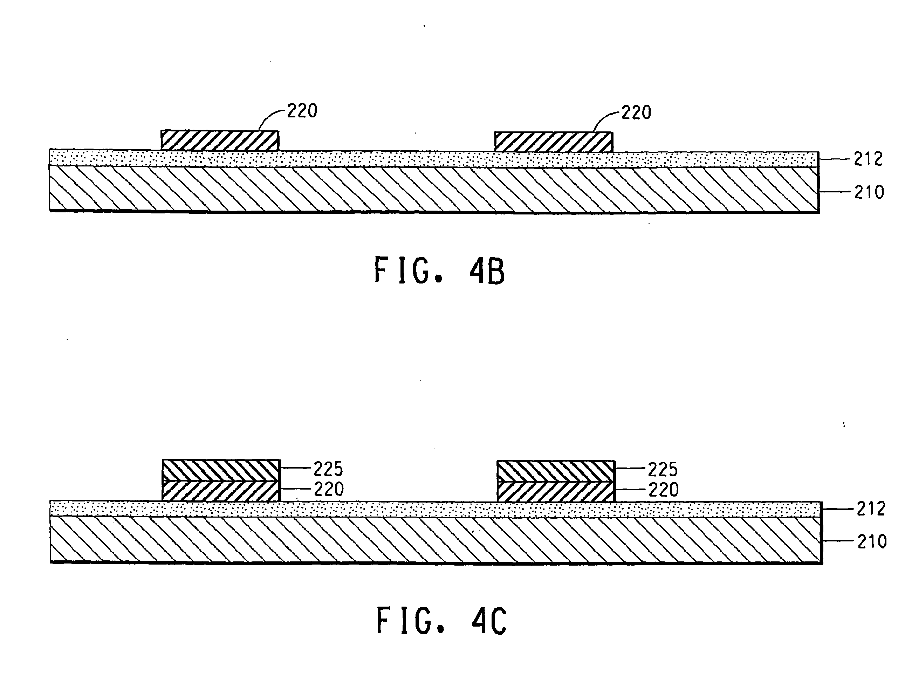

In **FIG. 4B,** a capacitor dielectric material is screen-printed onto the pretreated foil **210,** forming a first capacitor dielectric layer **220.** The capacitor dielectric material may be, for example, a thick-film dielectric ink. The dielectric ink may be formed of, for example, a paste. An example of a suitable capacitor dielectric paste is EP 310 obtainable from E. I. du Pont de Nemours and Company. The first capacitor dielectric layer **220** is then dried. In **FIG. 4C,** a second capacitor dielectric layer **225** is then applied, and dried. In an alternative embodiment, a single layer of capacitor dielectric material may be deposited through a coarser mesh screen to provide an equivalent thickness in one printing.

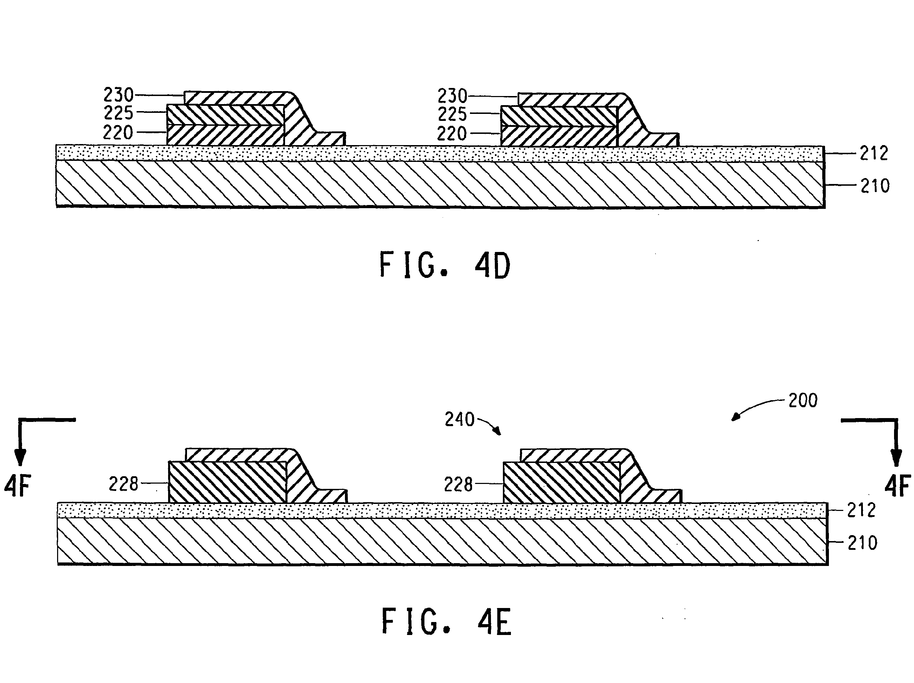

In **FIG. 4D,** an electrode **230** is formed over the second dielectric layer **225and** dried. The electrode **230** can be formed by, for example, screen-printing a thick-film metallic ink. When a copper foil **210** is used in conjunction with a copper underprint **212,** a copper electrode may be used. An example of a suitable copper electrode paste is EP 320 obtainable from E. I. du Pont de Nemours and Company. In general, the surface area of the dielectric layer **225** should be larger than that of the electrode **230.**

The first capacitor dielectric layer **220,** the second capacitor dielectric layer **225,** and the electrode **230** are then co-fired. Firing may be accomplished, for example, at a peak temperature of 900°C in a nitrogen thick-film furnace. The thick-film capacitor dielectric layers **220, 225** may be formed of, for example, a high dielectric constant functional phase such as barium titanate, various dopants and a glass frit phase. During co-firing, the glass frit phase softens, wets the functional and dopant phases and coalesces to create a dispersion of the functional phase and the dopants in a glass-ceramic matrix. At the same time, the copper electrode powders of the layer **230** are wetted by the softened glass frit phase and sinter together to form a solid electrode. The layer **230** has a strong bond to the high K dielectric **228** that results from the co-firing. The post-fired structure is shown in front elevation in **FIG. 4E.**

**FIG. 4F** is a plan view of the finished capacitor structure **200.** In **FIG. 4F,** four capacitor **240** structures on the foil **210** are illustrated. Any number of capacitor structures **240,** in various patterns, however, can be arranged on a foil **210.**

In the formed-on-foil capacitor discussed in this specification, the term "paste" or "ink" may correspond to a conventional term used in the electronic materials industry, and generally refers to a thick-film composition. Typically, the metal component of the underprint paste is matched to the metal in the metal foil. For example, if a copper foil were used, then a copper paste could be used as the underprint. Examples of other applications would be pairing silver and nickel foils with a similar metal underprint paste. Thick film pastes may be used to form both the underprint and the passive components.

Generally, thick-film pastes comprise finely divided particles of ceramic, glass, metal or other solids dispersed in polymers dissolved in a mixture of plasticizer, dispersing agent and organic solvent. Preferred capacitor pastes for use on copper foil have an organic vehicle with good burnout in a nitrogen atmosphere. Such vehicles generally contain very small amounts of resin, such as high molecular weight ethyl cellulose, where only small amounts are necessary to generate a viscosity suitable for screen-printing. Additionally, an oxidizing component such as barium nitrate powder, blended into the dielectric powder mixture, helps the organic component burn out in the nitrogen atmosphere. Solids are mixed with an essentially inert liquid medium (the "vehicle"), then dispersed on a three-roll mill to form a paste-like composition suitable for screen-printing. Any essentially inert liquid may be used as the vehicle. For example, various organic liquids, with or without thickening and/or stabilizing agents and/or other common additives, may be used as the vehicle.

High dielectric constant, (high K) thick-film capacitor dielectric pastes generally contain at least one high K functional phase powder and at least one glass powder dispersed in a vehicle system composed of at least one resin and a solvent. The vehicle system is designed to be screen-printed to provide a dense and spatially well-defined film. The high K functional phase powders may be described as powders that have bulk dielectric constant above 500 and can comprise perovskite-type ferroelectric compositions with the general formula ABO₃. Examples of such compositions include BaTiO₃; SrTiO₃; PbTiO₃; CaTiO₃; PbZrO₃; BaZrO₃ and SrZrO₃ or mixtures thereof. Other compositions are also possible by substitution of alternative elements into the A and/or B position, such as Pb(Mg_{1/3} Nb_{2/3})O₃ and Pb(Zn_{1/3} Nb_{2/3})O₃. A suitable high K functional phase powder is barium titanate obtained from Fuji Titanium. Doped and mixed metal versions of the above compositions are also suitable. Doping and mixing is done primarily to achieve the necessary end-use property specifications such as, for example, the necessary temperature coefficient of capacitance (TCC) in order for the material to meet industry definitions, such as "X7R" or "Z5U" standards.

The glasses in the pastes can be, for example, Ca-Al borosilicates, Pb-Ba borosilicates, Mg-Al silicates, rare earth borates, and other similar glass compositions. High K glass-ceramic powders, such as lead germanate (Pb₅Ge₃O₁₁), are preferred.

Pastes used to form the electrode layers may be based on metallic powders of either copper, nickel, silver, silver-containing precious metal compositions, or mixtures of these compounds. Copper powder compositions are preferred.

The capacitor structure described in this specification may be manufactured using multiple layers of dielectric and electrodes to increase the capacitance.

In the above example, the dielectric is described as formed by screen-printing thick-film paste. Other methods however, such as deposition by solution coating or sputtering may also be used. Alternatively, a dielectric may be applied and then photo defined. In addition, the electrode layers are described as formed by screen-printing. Other methods, however, such as deposition by sputtering, plating or evaporation of electrode metals onto the dielectric layer surface may also be used.

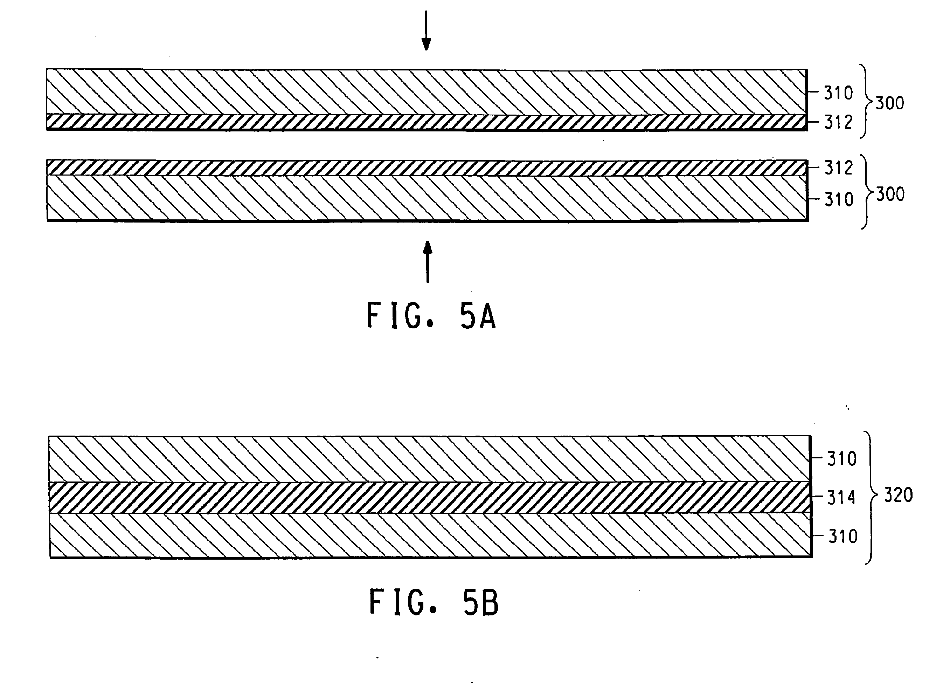

**FIGS. 5A-5B** illustrate, in side elevation, a general method of manufacture of a planar capacitor laminate.

**FIG. 5A** is a section view in front elevation of the first stage of manufacture of a planar capacitor laminate **320,** illustrated in **FIG. 5B,** in which a first metal foil **310** is provided. The foil **310** may be made from, for example, copper, copper-based materials, and other metals. Preferred foils include foils comprised predominantly of copper, such as reverse treated copper foils, double-treated copper foils, and other copper foils commonly used in the multilayer printed circuit board industry. Examples of some suitable copper foils are those which are available from Olin Brass (Somers Thin Strip) and JEC. The thickness of the foil **310** may be in the range of, for example, about 1-100 microns, preferably 3-75 microns, and most preferably 12-36 microns, corresponding to between about 1/3 oz and 1 oz copper foil.

A slurry material or a solution may be cast or coated onto foil **310,** dried and cured, forming a first dielectric layer **312,** the result being a coated metal foil **300.** The dielectric layer or layers of the laminate may be selected from organic, ceramic, ceramic filled organic and layers of mixtures thereof. Curing may be performed by baking, for example, at 350°C, if the slurry is of a thermoplastic nature. Higher curing temperatures can be used if the slurry is a thermoset material. Curing may be performed by drying, for example, at 120-200°C, if the polymer is intended to be only partially cured to create a "B" stage state of the polymer.

Solutions used to form the dielectric layer **312** may comprise, for example, a polymer dissolved in a solvent. Slurry materials may comprise, for example, a polymer-solvent solution with a high dielectric constant ("high K") filler/ceramic filler or functional phase. Suitable polymers for slurry or solution may include, but are not limited to for example, epoxy or polyimide resins. High K functional phases may be defined as materials with dielectric constants of greater than 500 and may include perovskites of the general formula ABO₃. Suitable fillers include, for example, crystalline barium titanate (BT), barium strontium titanate (BST), lead zirconate titanate (PZT), lead lanthanum titanate, lead lanthanum zirconate titanate (PLZT), lead magnesium niobate (PMN), and calcium copper titanate. Fillers may be in powder form. A suitable high K filler phase is barium titanate obtainable from Ferro Corporation, Tam Ceramics or Fuji Titanium.

Functional phases with dielectric constants below 500 may also be appropriate for other reasons. Such materials may include the oxides of titanium, tantalum, hafnium and niobium.

If the dielectric **312** is thermoplastic in nature or only partially cured, two pieces of the coated metal foil **300** may be laminated together under heat and pressure in the direction shown by the arrows in **FIG. 5A** to form the laminate structure **320** illustrated in **FIG. 5B.**

If the dielectric **312** is thermoset in nature, a thin adhesive layer may be applied to one or both of the dielectric layers **312.** Commercial thermoset dielectrics include polyimide grades available from E. I. du Pont de Nemours and Company.

Referring to **FIG. 5B,** lamination forms a single dielectric **324** from the layers **312.** The resulting dielectric **324** can be, for example, a thin layer, on the order of 4-25 microns after lamination. One embodiment of the planar capacitor laminate is a copper-dielectric-copper laminate. Embedded capacitor materials and processes that can used to form metal-dielectric metal structures include Probelec 81 CFP from Vantico licensed to Motorola and resin coated foil products such a MCF 6000E from Hitachi Chemical Company, MR-600 from Mitsui Metal and Smelting Co., Ltd., R-0880 from Matsushita Electric Works, Ltd., and APL-4000 from Sumitomo Bakelite Co., Ltd.

An alternative method of forming the dielectric **324** may be to cast a filled or unfilled thermoplastic polymer onto the foil **310** and to directly laminate a second, uncoated foil to the filled thermoplastic polymer. Yet another alternative method of manufacture includes forming the dielectric layer **324** separately as a single film and laminating it to a first foil **310** and a second foil **310** using heat and pressure. Yet another alternative method of manufacture includes forming the dielectric layer **324** separately as a single film and sputtering a metallic seed layer onto both sides of said separately formed dielectric layer and then plating additional metal onto the seed layer using electroless or electrolytic plating techniques. Suitable capacitor laminates include Interra™ HK 04 Series from E. I. du Pont de Nemours and Company, Interra™ HK 11 Series from E. I. du Pont de Nemours and Company, BC-2000 and BC-1000 from laminators licensed by Sanmina, FaradFlex Series from Oak-Mitsui Technologies, InSite™ Embedded Capacitor Series from Rohm and Haas Electronic Materials, TCC™ from Gould Electronics, and C-Ply from 3M.

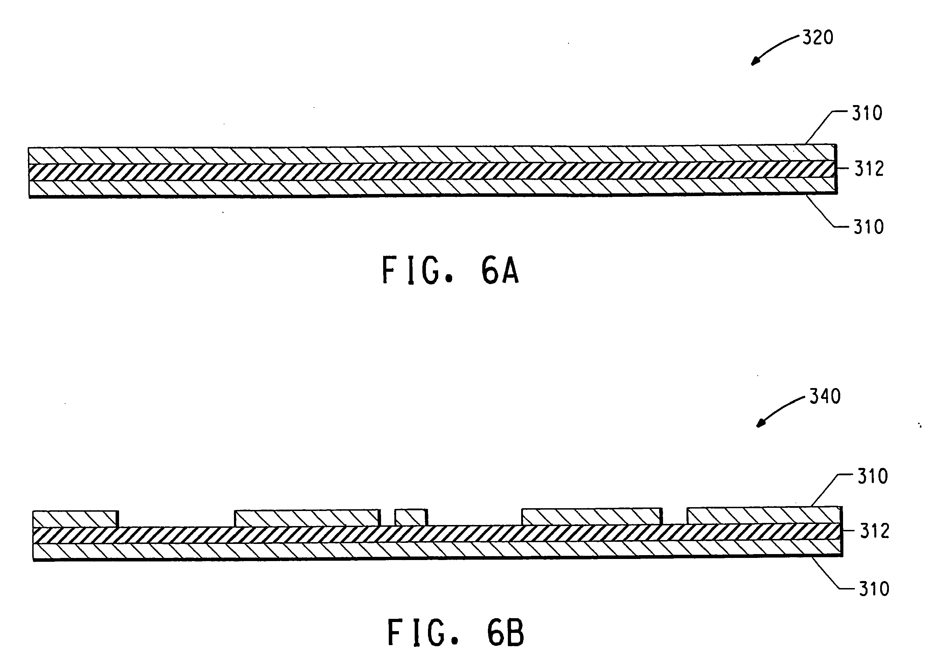

**FIGS. 6A-6B** illustrate, in side elevation, a general method of preparation of a planar capacitor laminate for manufacture of the power core device.

**FIG. 6A** shows, in side elevation, the planar capacitor laminate **320** from **FIG. 5B.** A photoresist (not shown in **FIG. 6A)** is applied to each of the foils **310.** However, only one of the photoresists is imaged and developed so that only one of the foils **310** is etched. All remaining photoresist is then stripped using standard printing wiring board processing conditions. An example of a suitable photoresist would be Riston® Photoresist available from E. I. du Pont de Nemours and Company.

**FIG. 6B** shows, in side elevation, the resulting etched laminate, **340,** illustrating one side has had portions of foil **310** removed by etching while the other foil **310** remains intact.

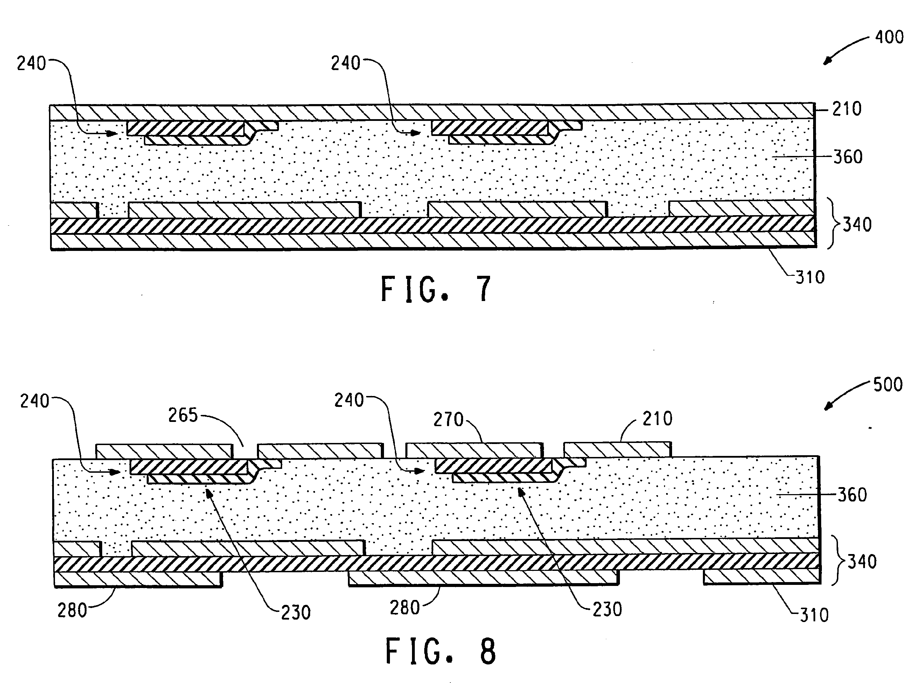

Referring to **FIG. 7,** the foil **210** containing the thick-film formed-on-foil capacitors **240** are laminated to the planar capacitor layer **340.** The capacitor-on-foil structure may be inverted and the component face of the foil laminated to the etched side of the planar capacitor laminate **340** to form the power core structure subpart as shown in **FIG. 7.** Alternatively, the foil side of the capacitor on foil structure may be laminated to the etched side of the planar capacitor laminate. The lamination can be performed, for example, using FR4 epoxy prepreg **360** in standard printing wiring board processes. In one embodiment, epoxy prepreg type 106 may be used. Suitable lamination conditions may be 185°C at 208 psig for 1 hour in a vacuum chamber evacuated to 28 inches of mercury. A silicone rubber press pad and a smooth PTFE filled glass release sheet may be in contact with the foils **210** and **310** to prevent the epoxy from gluing the lamination plates together. The dielectric prepreg and laminate materials can be any type of dielectric material such as, for example, standard epoxy, high Tg epoxy, polyimide, polytetrafluoroethylene, cyanate ester resins, filled resin systems, BT epoxy, and other resins and laminates that provide insulation. Release sheet may be in contact with the foils to prevent the epoxy from gluing the lamination plates together between circuit layers. The resulting subpart **400** is encapsulated by foil **210** on one side and foil **310** on the other.

One skilled in the art would understand that alternative designs of the power core may include laminating said singulated capacitor layer component side up to said patterned planar capacitor laminate. Such approaches would require different etching patterning and via formation to connect the appropriate layers. Alternative designs such as these may achieve the same design requirements. Referring to **FIG. 8,** after lamination, a photo-resist is applied to the formed-on-foil capacitor foil **210** and the planar capacitor foil **310.** The photo-resist is imaged, developed and the metal foils are etched and the photoresist is stripped using standard printing wiring board processing conditions. The etching produces a trench **265** in the foil **210,** which breaks electrical contact between the first electrode **230 and** the foil **210** creating a second electrode **270** from foil **210.** Any associated circuitry is also created from foil **210.** The etching also produces electrodes **280** and associated circuitry on the planar capacitor foil **310.**

It should be understood that the power core may be formed by other sequences of lamination of layers, for example, by first laminating the imaged side of the planar capacitor laminate 340 shown in **FIG. 6** to other printed wiring board layers, applying photoresist to the unimaged foil 310, etching the foil, stripping the photoresist, and then laminating the embedded singulated capacitor layer to the planar capacitor laminate.

### EXAMPLES

A structure containing planar capacitance laminates and discrete embedded ceramic capacitors was designed and tested. The planar capacitance laminates formed power distribution planes and the embedded capacitors were designed for placement on two internal metal layers. There were three different capacitor designs: Type A , Type B , and Type C. For each type, multiple capacitors with 1 mm², 4mm², and 9mm² effective capacitor size (area) were placed on each of the two internal metal layers. The capacitor designs differed in the relative position and size of the foil electrodes, the size of the dielectric, and the size of the screen printed copper electrode. They further differed in the design of the clearance (gap) that insulates the two copper foil electrodes, and they differed in the location and number of vias that connect the embedded capacitor to the next metal layer above. For example, in the 9 mm² size capacitors,Type A design featured 4 via connections, Type B had 28 vias, and Type C had 52 vias. For all three types the screen printed conductor formed one electrode of the capacitor and the foil, separated by the dielectric from the screen printed conductor, served as the other capacitor electrode.

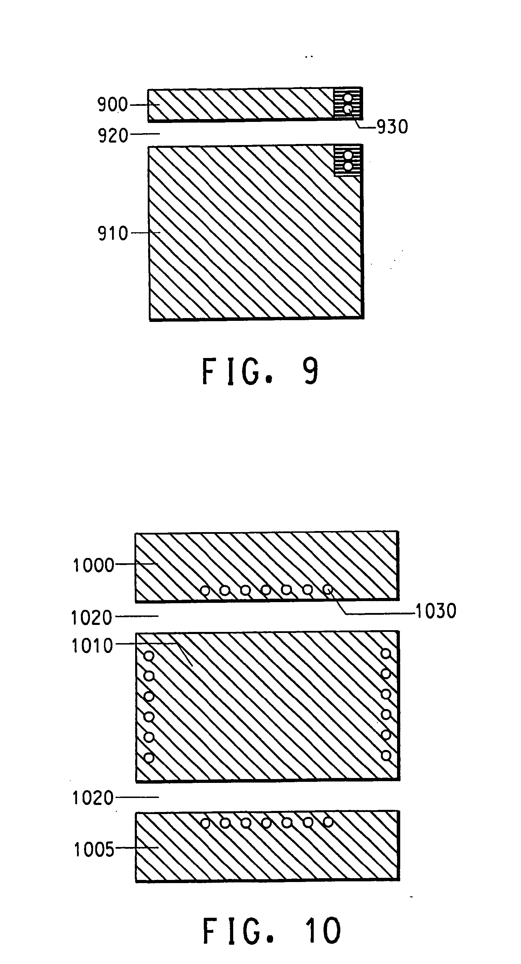

The Type A discrete capacitor design shown in **FIG. 9,** when viewed from the foil side, had a square form factor with the foil electrode (900) connecting to the screen printed conductor extending across the width of the capacitor. This electrode was separated from the second foil electrode (910) serving as the other capacitor electrode by a 250-micron gap (920). This gap extended across the width of the capacitor. This second foil electrode extended across the width of the capacitor with a length about 4/5ths of the capacitor length. Via connections (930), 150 microns in diameter were formed to the next metal layer above the capacitor and were placed in the upper right corner, when viewed from the foil side, of each of the two electrodes. For all sizes two vias were used in each electrode.

The Type B discrete capacitor design shown in **FIG. 10,** when viewed from the foil side, had a square form factor with two foil electrodes (1000, 1005) connected to the screen printed conductor. Each electrode extended across the width of the capacitor at the top and bottom of the capacitor, each about 1/5 the length of the capacitor in length. These electrodes were separated from the second foil electrode (1010) serving as the other capacitor electrode by 250-micron gaps (1020) extending across the width of the capacitor. This second electrode (1010) was slightly less than 3/5ths the length of the capacitor in length. Via connections (1030), 150 microns in diameter were formed to the next metal layer above the capacitor and were uniformly placed in a row across the width of the capacitor electrodes at the top and bottom of the capacitor, connecting to the screen printed conductor. The second electrode of the capacitor had a row of vias along the length of each side of the capacitor. For the 9-mm² size, twenty-eight vias were used.

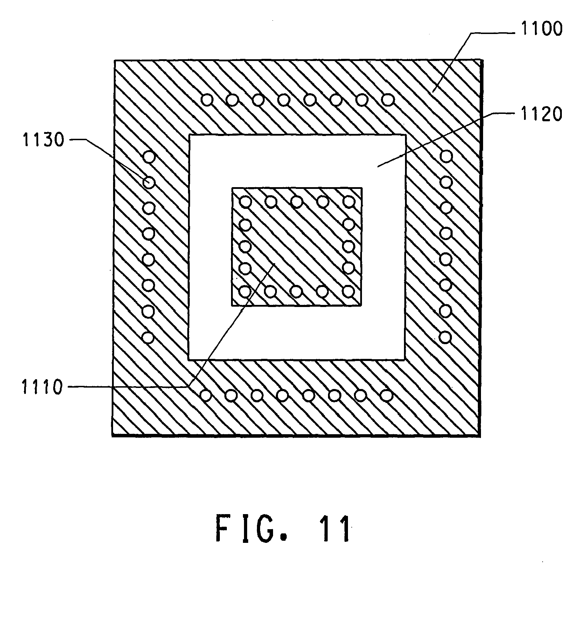

The Type C discrete capacitor design shown in **FIG. 11,** when viewed from the foil side, had a square form factor. The foil electrode (1100) connected to the screen printed conductor formed a square "picture frame" like feature around the second capacitor electrode (1110). This second capacitor electrode was also square and was separated from the surrounding first electrode by a continuous 250-micron gap (1120). The 150 micron diameter via connections (1130) to the next metal layer above the capacitor were uniformly placed on all four sides of the first capacitor electrode connected to the screen printed conductor, a total of 32 vias for the 9-mm² size. The second electrode of the capacitor had 20 vias for the 9-mm² size, uniformly placed around the perimeter of the electrode.

The electrical parameters (capacitance, resistance, inductance) of individual capacitors, with and without via connections, were measured. The impedance vs frequency response for individual capacitors was measured and the measured responses were compared with the curves generated by a simulation model. The model was then used to simulate the impedance of several capacitor arrays, applying conservative, as well as, advanced design rules for the embedded capacitor arrays.

### Results:

The capacitance, resistance, and inductance for Type A, B, and C type capacitors of 1, 4, and 9 mm² size, without via connections were measured using a Vector Network Analyzer and a two port measurement methodology using SOLT calibration. Coaxial style ground - signal probes with 500 micron spacing were used to measure capacitor S parameters and the real and imaginary impedance components of the capacitors were calculated. In Table 1 (without vias) and Table 2 (with vias), Capacitors 1, 4 and 9 are of the Type A design, Capacitors 2, 5 and 8 are of the Type B design and Capacitors 3, 6 and 7 are of the Type C design. Capacitors 1 through 3 were 1 mm X 1 mm in size, capacitors 4 through 6 were 2mm X 2mm in size, and capacitors 7 through 9 were 3mm X 3mm in size.

**TABLE 1 WITHOUT VIAS**

| | **CAPACITANCE** | **ESR (RESISTANCE)** | **INDUCTANCE** |
|---|---|---|---|
| CAPACITOR 1 | 1.26nF | 36 mohms | 48pH |
| CAPACITOR 2 | 1.17nF | 50 mohms | 47.3pH |
| CAPACITOR 3 | 1.63nF | 34 mohms | 41.6pH |
| CAPACITOR 4 | 5.15nF | 8 mohms | 33.7pH |
| CAPACITOR 5 | 5.16nF | 10.7 mohms | 35.07pH |
| CAPACITOR 6 | 6.16nF | 10.7 mohms | 35.48pH |
| CAPACITOR 9 | 10.6nF | 7.9 mohms | 35.44pH |
| CAPACITOR 8 | 11nF | 10 mohms | 40pH |
| CAPACITOR 7 | 13.6nF | 8.9 mohms | 33.8pH |

This shows that the capacitance increases with size, as expected, and does not vary much with the design type. Inductance values of all three types, without via connections, are fairly similar. The same parameters for capacitors of Type A, B, and C with via connections were measured using the same equipment and methodology.

**TABLE 2 WITH VIAS**

| | **CAPACITANCE** | **ESR (RESISTANCE)** | **INDUCTANCE** |
|---|---|---|---|
| CAPACITOR 1 | 1.05nF | 89mohms | 382pH |
| CAPACITOR 2 | 1.20nF | 86.5mohms | 125pH |
| CAPACITOR 3 | 1.7nF | 37.1 mohm | 74.6pH |
| CAPACITOR 4 | 6.49nF | 50.1 mohms | 308pH |
| CAPACITOR 5 | 5.28nF | 128mohms | 120.5pH |
| CAPACITOR 6 | 6.6nF | 20.9mohms | 65.17pH |
| CAPACITOR 9 | 15.3nF | 100mohms | 218.2pH |
| CAPACITOR 8 | 13.26nF | 15.4mohm | 115pH |
| CAPACITOR 7 | 13.2nF | 17.3mohms | 79.39pH |

The data showed that the capacitor type and the number of vias and their location greatly affects the resistance and inductance of the capacitor.

The impedance vs frequency response for two Type C capacitors with and without via connections were measured. For capacitor 3, listed above, the results showed an impedance of about 30 milliohms for the conditions both with and without vias and a resonance frequency shift due to the via connections from about 900 MHz for the capacitor without vias to about 500 MHz with vias. For capacitor 6 without vias the results showed an impedance of about 10 milliohms at a resonant frequency of about 350 MHz and for the condition with vias an impedance of about 20 milliohms at a resonant frequency of about 200 MHz

Good correlation between the measured frequency response and the modelled response for the two capacitor types of different sizes was observed.

Simulation of the planar capacitor impedance vs frequency response for the planar capacitor with and without the contribution of the through-hole inductance was performed. The area of the through-hole interconnections was about 1% of the total area. The frequency response of one planar capacitor without the through-hole inductance had an impedance of about 80 milliohms at a resonant frequency of about 300MHz while the frequency response with two planar capacitors with the through-hole inductances had an impedance of about 30 milliohms at a resonant frequency of about 250 MHz.

Based on the measured results and modelling results of the various individual capacitors, modeling and simulation for an array of 64 discrete embedded capacitors applying a conservative design rule of a minimum spacing between capacitors of 500 *µ*m was performed. Capacitors of different sizes and different resonance frequencies were selected so that the capacitor array impedance response yielded fairly uniform, low impedance values. The impedance achieved in the 100MHz to 1 GHz range was less than about 40 mΩ.

Based on measured and modeled results applying more demanding spacing design rules for an array of 1.15 to 2.5 mm per side sized capacitors an impedance of 0.7 mΩ was achieved in the 100 MHz to 1 GHz frequency range.

A simulation model for 100 uncoupled transmission lines routed on a 38 micron thick substrate with a relative dielectric constant of 3.8 separated from a power plane was designed. The transmission lines were spaced 10 mils apart, were 15 mm long, 2.82 mils in width and each line was terminated with 99 ohm resistors to the power and to the ground plane (a 50 ohm line termination). In one case the power plane was on a 14-micron thick substrate opposite a ground plane. The substrate having a relative dielectric constant of 3.8 and a Loss Tangent of 0.02. In another case the power plane was on a 14-micron thick substrate opposite the ground plane with a relative dielectric constant of 11 and a Loss Tangent of 0.02. Output drivers producing a 5 GHz square wave bit stream with 80pS pulse width with 20 pS rise and fall times were used to drive all 100 transmission lines and the "eye" pattern response of a centrally located transmission line was obtained. The eye pattern for the first case, a power plane substrate with a dielectric constant of 3.8, the resulting eye opening height was 2.4799 Volts. In the response for the second case with the same conditions and a power plane substrate with a dielectric constant of 11 the eye opening height was 2.6929 Volts, a significant improvement over the first case. The spacing between the transmission lines was changed to 3 mils resulting in 50 coupled line pairs. With all other conditions remaining the same the eye pattern response was obtained. The eye pattern for this first coupled line case, a power plane substrate with a dielectric constant of 3.8, resulted in an eye opening height of 2.5297 Volts. The response for the second coupled line case with the same conditions and a power plane substrate with a dielectric constant of 11 the eye opening height was 2.6813 Volts, an improvement over the first case. The higher dielectric constant power plane substrate again resulted in an improved eye pattern response.

A simulation model for a configuration that included discrete decoupling capacitors in addition to the planar power plane substrates for the analysis of simultaneous switching noise (SSN) was constructed. This simulation model had 50 coupled transmission line pairs on a 38-micron thick substrate with a relative dielectric constant of 3.8 separated from a power plane. The transmission lines were spaced 3 mils apart, were 15 mm long, 2.82 mils in width and each line was terminated with 99 ohm resistors to the power and ground planes (a 50 ohm line termination). In some cases the power plane was on a 14-micron thick substrate opposite a ground plane. The substrate had a relative dielectric constant of 3.8 and a Loss Tangent of 0.02. In other cases the power plane was on a 14-micron thick substrate opposite the ground plane with a relative dielectric constant of 11 and a Loss Tangent of 0.02. Output drivers producing a 5 GHz square wave bit stream with 80pS pulse width with 20 pS rise and fall times were used to drive all 100 transmission lines simultaneously and the noise voltage produced on the power plane was obtained. Variations in the type, SMT or embedded discrete, and quantity of capacitors were analyzed. The capacitors were located in an area at the driver or near end of the transmission lines.

In one case a configuration having 50 pairs of coupled lines (100 lines total), twenty-five SMT capacitors were placed at the driver end of the transmission line at every other line pair starting at line pair 1, the next at line pair 3 and ending at line pair 50. The planar power plane substrate had a dielectric constant of 3.8. Each SMT capacitor had a capacitance of 100 nF, an equivalent series inductance (ESL) of about 205 pH and an equivalent series resistance (ESR) of 100 milliohms. A 5GHz square wave bit stream with 80pS pulse width with 20 pS rise and fall times was used to drive all 100 transmission lines simultaneously and the noise voltage on the power plane was measured. This was duplicated for embedded discrete capacitors where each capacitor had a capacitance of 1 nF, an equivalent series inductance (ESL) of about 33 pH and an equivalent series resistance (ESR) of 9 milliohms. The planar power plane substrate in this configuration had a dielectric constant of 11. The voltage variation on the power plane for the 25 SMT capacitors with a planar power plane substrate dielectric constant of 3.8 had peak to peak voltage variation of about -0.1 Volts to +0.15 Volts while the voltage variation on the power plane for the 25 embedded discrete capacitors with a planar power plane substrate dielectric constant of 11 had a peak-to-peak voltage variation on the power plane of about -0.05 Volts to +0.05 Volts. A significant reduction in power plane noise produced by the simultaneous switching of output drivers resulted from the use of embedded capacitors and a higher dielectric constant planar power plane substrate.

Additional SMT capacitors were added to the SMT model to determine the number of SMT capacitors that would provide the equivalent noise reduction of the embedded capacitor configuration. Fifty, seventy-five and one hundred SMT capacitors were modeled. The fifty SMT capacitor configuration was achieved by placing capacitors at the driver end of every line pair. The seventy-five capacitor configuration was achieved by adding a second group of capacitors each located at the driver end of every other line pair and the one hundred capacitor configuration was achieved by adding SMT capacitors to produce a two by fifty array of capacitors at the driver end of the first pair thru 50^{th} pair of transmission lines.

The voltage variation on the power plane for fifty SMT capacitors and a planar substrate dielectric constant of 3.8 had a peak-to-peak voltage variation on the power plane of about-0.12 Volts to +0.12 Volts. The voltage variation on the power plane for seventy-five SMT capacitors and a planar substrate dielectric constant of 3.8 had a peak-to-peak voltage variation on the power plane of about -0.1 Volts to +0.1 Volts. The voltage variation on the power plane for one hundred SMT capacitors and a planar substrate dielectric constant of 3.8 had a peak-to-peak voltage variation on the power plane of about -0.075 Volts to +0.1 Volts. All four of the SMT capacitor configurations resulted in higher power plane noise, or voltage variation, as a result of simultaneous switching of output drivers than the embedded discrete capacitor configuration with twenty-five capacitors and a power plane dielectric constant of 11.

## Claims

**1.** A power core comprising:
at least one embedded singulated capacitor layer containing at least one embedded singulated capacitor; and
at least one planar capacitor laminate;
wherein at least one planar capacitor laminate serves as a low inductance path to supply a charge to at least one embedded singulated capacitor; and
wherein said embedded singulated capacitor is connected in parallel to said planar capacitor laminate.

**2.** The power core of claim 1 wherein said embedded singulated capacitor is a formed-on-foil ceramic capacitor.

**3.** The power core of claim 1 wherein said embedded singulated capacitor is a cured-on-foil ceramic filled polymer-based capacitor.

**4.** The power core of claim 1 wherein said planar capacitor laminate comprises an organic dielectric layer.

**5.** The power core of claim 1 wherein said planar capacitor laminate comprises a ceramic dielectric layer.

**6.** The power core of claim 1 wherein said planar capacitor laminate comprises a ceramic material filled organic dielectric layer
wherein the ceramic material of said layer has a dielectric constant of greater than 500.

**7.** The power core of claim 1 wherein said planar capacitor dielectric laminate comprises a ceramic material filled organic dielectric layer wherein the ceramic material of said layer has a dielectric constant of less than 500.

**8.** The power core of claim 1 wherein said planar capacitor laminate is a copper-dielectric-copper laminate.

**9.** The power core of claim 8 wherein said copper-dielectric-copper laminate comprises one or more dielectric layers selected from an organic layer, a ceramic-filled organic layer, a ceramic layer, and mixtures thereof.

**10.** A method for making a power core structure comprising;
providing a planar capacitor laminate having at least one patterned side;
providing a singulated capacitor structure;
laminating said singulated capacitor structure to the patterned side of said planar capacitor laminate; and
connecting said singulated capacitor structure in parallel to said planar capacitor laminate.

**11.** A method for making a power core structure comprising;
providing a planar capacitor laminate having a patterned side and a non-patterned side;
providing a formed-on-foil singulated capacitor structure having a foil side and a component side;
laminating said component side of said formed-on-foil singulated capacitor structure to said patterned side of said planar capacitor laminate; and
connecting said formed-on-foil singulated capacitor structure in parallel to said planar capacitor laminate.

**12.** A method for making a power core structure comprising:
providing a planar capacitor laminate having a first patterned side and a second patterned side;
providing a formed-on-foil singulated capacitor structure having a foil side and a component side; and
laminating said component side of said formed-on-foil singulated capacitor structure to said first patterned side of said planar capacitor laminate; and
connecting said singulated capacitor structure in parallel to said planar capacitor laminate.

**13.** A method for making a power core structure comprising:
providing a planar capacitor laminate having at least one patterned side;
providing at least one foil structure comprising at least one formed-on-foil singulated capacitor, having a foil side and a component side; and
laminating said foil side of said foil structure to said patterned side of said planar capacitor structure;
etching said foil side of said foil structure and etching said non-patterned side of said planar capacitor structure; and
connecting said singulated capacitor structure in parallel to said planar capacitor laminate.

**14.** The method of claim 11 further comprising patterning both the non-patterned side of said planar capacitor laminate and the foil side of said formed-on-foil singulated capacitor structure.

**15.** The method of claim 10 wherein signal lines are incorporated and interconnected on the same layer as said singulated capacitor structure.

**16.** The method of claim 10 wherein resistors are incorporated and interconnected on the same layer as said singulated capacitor structure.

**17.** The method of claim 10 wherein a resistive element is incorporated into said planar capacitor laminate to form a resistor capacitor element.

**18.** The method of claim 10 wherein said formed-on-foil singulated capacitor structure is formed by the method comprising:
providing a metallic foil;
forming at least one first dielectric over the foil;
forming at least one first electrode over the first dielectric; and
co-firing the first dielectric and the first electrode.

**19.** The method of claim 10 wherein said singulated capacitor structure is formed by the method comprising:
providing a metallic foil;
forming at least one first dielectric over the foil and curing the dielectric layer;
forming at least one first electrode over the first dielectric; and
curing the first electrode.

**20.** The method of claim 10 wherein said singulated capacitor structure is formed by the method comprising:
providing a metallic foil;
forming at least one first dielectric over the foil and firing said dielectric; and
forming a first electrode over the first dielectric.

**20.** The method of claim 10 wherein said singulated capacitor structure comprises a metallic foil selected from copper, invar, nickel, nickel-coated copper, and other metal that has a melting point above the firing temperature for thick film pastes.

**21.** The method of claim 10 wherein said singulated capacitor structure comprises metallic foil that has been treated with an underprint layer.

**22.** The method of claim 10 wherein said planar capacitor laminate is formed by the method comprising:
providing a first metallic foil;
providing a first dielectric layer on said first metallic foil forming a first coated metallic foil;
providing a second metallic foil;
providing a second dielectric layer on said second metallic foil forming a second coated metallic foil; and
laminating said first and second coated metallic foils together.

**23.** The method of claim 10 wherein said planar capacitor laminate is formed by the method comprising:
providing a first metallic foil;
providing a dielectric layer on said first metallic foil thus forming a coated metallic foil with a dielectric layer side and a metallic foil side;
providing a second metallic foil; and
laminating said second metallic foil to said dielectric layer side of said coated metallic foil.

**24.** The method of claim 10 wherein said planar capacitor laminate is formed by the method comprising:
providing a first metallic foil;
providing a first dielectric layer having a first side and a second side;
providing a second metallic foil; and
simultaneously laminating said first metallic foil to said first side of said dielectric layer and said second metallic foil to said second side of said dielectric layer.

**25.** The method of claim 10 wherein said planar capacitor laminate is formed by the method comprising:
providing a first metallic foil;
providing a first dielectric layer on said first metallic foil and firing said dielectric thereby forming a first coated metallic foil; and
forming a first electrode over the fired dielectric

**26.** The method of claim 11 wherein said planar capacitor comprises a first metal layer, a dielectric layer, and second metal layer and wherein at least one metal layer is formed by sputtering and plating.
